# EUROPÄISCHE PATENTSCHRIFT

(11) **EP 3 090 267 B1**
(45) Veröffentlichungstag und Bekanntmachung des Hinweises auf die Patenterteilung: **25.05.2022**
(21) Anmeldenummer: 15705271.3
(22) Anmeldetag: 12.02.2015
(51) Int. Cl.: G01R 31/08

(54) **VERFAHREN ZUM ORTEN EINES KURZSCHLUSSES IN EINEM WENIGSTENS EINEN LEITUNGSABSCHNITT UMFASSENDEN STROMNETZ**
METHOD FOR LOCATING A SHORT CIRCUIT IN AN ELECTRICAL GRID COMPRISING AT LEAST ONE LINE SECTION
PROCÉDÉ DE LOCALISATION D'UN COURT-CIRCUIT DANS UN RÉSEAU ÉLECTRIQUE COMPRENANT AU MOINS UN TRONÇON DE LIGNE

(30) Priorität: 04.03.2014 DE 102014203906
(43) Veröffentlichungstag der Anmeldung: 09.11.2016
(73) Patentinhaber: Siemens Mobility GmbH, 81739 München (DE)
(72) Erfinder: BIANCHI, Roberto, 91056 Erlangen (DE)
(86) Internationale Anmeldenummer: PCT/EP2015/052980
(87) Internationale Veröffentlichungsnummer: WO 2015/132060

(56) Entgegenhaltungen:
- DE-B1- 2 907 857
- US-A- 4 755 903
- DENIO T SILVA ET AL: "Fault location on overhead power transmission lines by measuring currents from shield wires", INDUSTRY APPLICATIONS (INDUSCON), 2010 9TH IEEE/IAS INTERNATIONAL CONFERENCE ON, IEEE, 8. November 2010 (2010-11-08), Seiten 1-6, XP031935616, DOI: 10.1109/INDUSCON.2010.5740046 ISBN: 978-1-4244-8008-1
- WANG ZANJI ET AL: "A novel method to determine leakage inductance for internal fault analysis in power transformer", POWER SYSTEM TECHNOLOGY, 2000. PROCEEDINGS. POWERCON 2000. INTERNATION AL CONFERENCE ON 4-7 DECEMBER 2000, PISCATAWAY, NJ, USA,IEEE, 4. Dezember 2000 (2000-12-04), Seiten 795-800, XP010528098, ISBN: 978-0-7803-6338-0
- None

## Beschreibung

Die Erfindung betrifft ein Verfahren zum Orten eines Kurzschlusses in einem wenigstens einen Leitungsabschnitt umfassenden Stromnetz.

Des Weiteren betrifft die Erfindung ein Distanzschutzrelais zum Orten eines Kurzschlusses in einem wenigstens einen Leitungsabschnitt umfassenden Stromnetz, insbesondere eines Autotransformatorsystems.

Für Betreiber eines Stromnetzes, beispielsweise Energieunternehmen oder Bahnunternehmen, gewinnt eine schnelle Lokalisierung und Beseitigung von Kurzschlüssen im betriebenen Stromnetz zunehmend an Bedeutung. Hierzu werden üblicherweise Distanzschutzrelais eingesetzt, welche eine Lokalisierung eines Kurzschlusses anhand einer gemessenen Kurzschlussreaktanz ermöglichen. Die jeweilig gemessene Kurzschlussreaktanz und die jeweilig hieraus ermittelte Kurzschlussdistanz, das heißt, der jeweilige Ort, an dem ein Kurzschluss vorliegt, können von einem Distanzschutzrelais in Form einer elektronischen Information einem Betreiber eines Stromnetzes bereitgestellt werden. Diese Information kann vom Betreiber des Stromnetzes dazu benutzt werden, ein Wartungspersonal gezielt an den Ort des Kurzschlusses zu entsenden. Dies erspart Suchzeiten und erhöht somit die Verfügbarkeit der Infrastruktur. Gleichzeitig werden Kosten gespart, da das Wartungspersonal effizienter arbeiten kann.

Die Kurzschlussortung basiert üblicherweise auf einer Umrechnung der gemessenen Kurzschlussreaktanz in die jeweilige Kurzschlussdistanz. Heutige Distanzschutzrelais können die Kurzschlussreaktanz in die jeweilige Kurzschlussdistanz nur dann umrechnen, wenn das Verhältnis dieser zwei Größen, zumindest abschnittweise, linear ist. Bei Systemen mit Booster-Transformatoren oder Autotransformatoren, ist eine Distanz-Reaktanz-Kurve jedoch nicht linear. Des Weiteren entsteht bei solchen Systemen durch die Einführung eines Negative-Feeders neben einem Positive-Feeder eine zweite Distanz-Reaktanz-Kurve, welche ebenfalls nicht linear ist.

In der DE 29 07 857 B1 ist eine Schaltungsanordnung zur Bestimmung der Reaktanz einer Energieübertragungsleitung im Kurzschlussfalle beschrieben, mit der der Kurzschluss besonders schnell bestimmt werden kann.

In herkömmliche Distanzschutzrelais kann bislang nur eine abschnittweise lineare Distanz-Reaktanz-Kurve eingegeben werden. Dies erfolgt durch eine Eingabe einer Kurzschlussreaktanz pro Kilometer, das heißt der Steigung der Distanz-Reaktanz-Kurve, und einer Länge von jedem Netzabschnitt, für den eine lineare Distanz-Reaktanz-Kurve ermittelbar ist. Da die Umrechnung von Kurzschlussreaktanz in Kurzschlussdistanz heute nur für lineare Distanz-Reaktanz-Kurven möglich ist, wird die Berechnung der Kurzschlussdistanz in Autotransformatorsystemen entweder in Untereinheiten, sogenannte Substation Controller, verschoben oder einfach per Hand vorgenommen. Eine Implementation in einen Station Controller erfordert aufwändige Anpassungsarbeiten. Die Berechnung per Hand ist fehleranfällig und nicht mehr zeitgemäß. Des Weiteren ist das Generieren von Distanz-Reaktanz-Kurven auf herkömmliche Art und Weise durch abschnittsweises mehrfaches Messen von Kurzschlussreaktanzwerten bzw. durch kostenintensive Simulationen für einen Betreiber eines Stromnetzes aufwändig und fehleranfällig.

Aufgabe der vorliegenden Erfindung ist es, eine neue technische Maßnahme zum Orten eines Kurzschlusses in einem wenigstens einen Leitungsabschnitt umfassenden Stromnetz bereitzustellen.

Die Lösung der Aufgabe erfolgt durch die Merkmale der unabhängigen Ansprüche 1 und 8. Vorteilhafte Ausgestaltungen sind in den Unteransprüchen angegeben.

Erfindungsgemäß wird zur Ortung eines Kurzschlusses in einem Leitungsabschnitt eines Stromnetzes eine mathematische Funktion hergeleitet, welche einen tatsächlichen Verlauf einer Distanz-Reaktanz-Kurve sehr exakt wiedergibt. Dies macht eine Umrechnung einer gemessenen Kurzschlussreaktanz in den jeweiligen Ort des Kurzschlusses innerhalb des Leitungsabschnitts auch bei nicht linearen Distanz-Reaktanz-Kurven möglich. Eine Distanz-Reaktanz-Kurve kann somit gemäß der Erfindung durch eine allgemeine mathematische Funktion modelliert werden, anstatt, wie bislang üblich, eine Distanz-Reaktanz-Kurve durch Geraden zu modellieren.

Die mathematische Funktion kann beispielsweise ein Polynom, insbesondere ein Spline oder eine exponentielle Funktion, sein. Die Art der jeweilig verwendeten mathematischen Funktion ist im Rahmen der Erfindung jedoch nicht auf eine Verwendung von Polynomen begrenzt.

Das erfindungsgemäße Verfahren ermöglicht es insbesondere, eine Berechnung eines Fehlerortes in einem Autotransformatorsystem direkt in einem Distanzschutzrelais vorzunehmen, was bisher nicht möglich war. Hierdurch kann eine herkömmlich erforderliche Sonderprogrammierung eines Station Controllers entfallen. Zudem sind keine Arbeiten und Berechnungen per Hand erforderlich. Ferner ist keine aufwändige Messkampagne oder Simulation erforderlich. Ein zur Durchführung des erfindungsgemäßen Verfahrens eingerichtetes Distanzschutzrelais bildet eine einfache Schnittstelle zu einem Netzbetreiber aus.

Im Falle eines Kurzschlusses in einem Leitungsabschnitt des Stromnetzes kann ein zur Durchführung des erfindungsgemäßen Verfahrens eingerichtetes Distanzschutzrelais zunächst die mit dem Kurzschluss verbundene Kurzschlussreaktanz ermitteln. Anschließend kann das Distanzschutzrelais durch Vergleich der ermittelten Kurzschlussreaktanz mit einer der hergeleiteten mathematischen Funktion zugeordneten Distanz-Reaktanz-Kurve ermitteln, an welchem Ort innerhalb des Leitungsabschnitts der Kurzschluss vorliegt. Daraufhin kann das Distanzschutzrelais eine Information, welche das Vorliegen des Kurzschlusses, den damit verbundenen Kurzschlussreaktanzwert und den Ort des Kurzschlusses innerhalb des Leitungsabschnitts enthält, generieren und an den Betreiber des Stromnetzes senden.

Gemäß einer vorteilhaften Ausgestaltung wird die mathematische Funktion in Form eines Polynoms vom Grad n≥2 hergeleitet. Hierdurch lässt sich die mathematische Funktion sehr genau an einen tatsächlichen Verlauf einer tatsächlichen Distanz-Reaktanz-Kurve annähern, um eine sehr exakte Ortung eines Kurzschlusses innerhalb des Leitungsabschnitts zu ermöglichen.

Nach einer weiteren vorteilhaften Ausgestaltung werden als abschnittspezifische Parameter des Leitungsabschnitts an wenigstens drei Messorten des Leitungsabschnitts gemessene Kurzschlussreaktanzwerte des Leitungsabschnitts erfasst. Die mathematische Funktion kann aus den Kurzschlussreaktanzwerten und den Messorten durch Interpolation hergeleitet werden. Wird als mathematische Funktion beispielsweise ein Polynom vom Grad n verwendet, müssen lediglich n+1 Kurzschlussreaktanzmessungen an dem Leitungsabschnitt durchgeführt werden. Die mathematische Funktion kann folglich aus sehr wenigen Kurzschlussmesswerten hergeleitet werden. Weist das Polynom beispielsweise einen Grad n=2 auf, müssen lediglich drei Kurzschlussreaktanzwerte eines Leitungsabschnitts gemessen werden. Diese Kurzschlussreaktanzwerte können zusammen mit dem jeweiligen Messort innerhalb des Leitungsabschnitts in ein Distanzschutzrelais eingegeben werden, welches zur Durchführung des erfindungsgemäßen Verfahrens eingerichtet ist. Das Distanzschutzrelais kann dann den Ort eines erfassten Kurzschlusses innerhalb eines Leitungsabschnitts selbsttätig ermitteln. Dies kann entsprechend für jeden Leitungsabschnitt eines Stromnetzes durchgeführt werden, so dass ein komplettes Leitungssystem eines Stromnetzes mit einer geringen Anzahl von Kurzschlussreaktanzmessungen beschreiben werden kann. Die Anzahl der zu messenden Kurzschlussreaktanzwerte kann weiterhin dadurch reduziert werden, dass ein Messort an einem Ende eines Leitungsabschnitts gleichzeitig als Messort an einem Anfang eines weiteren Leitungsabschnitts gewählt wird. Hierdurch müssen der Messort und ein an diesem Messort gemessener Kurzschlussreaktanzwert nur einmal in ein zur Durchführung des erfindungsgemäßen Verfahrens eingerichtetes Distanzschutzrelais eingegeben werden. Messungen von Kurzschlussreaktanzwerten können beispielsweise am Anfang, in der Mitte und am Ende eines ersten Leitungsabschnitts eines Stromnetzes vorgenommen werden. An dem zweiten und jedem weiteren Leitungsabschnitt des Stromnetzes müssen dann lediglich in der Mitte und am Ende des jeweiligen Leitungsabschnitts Messungen von Kurzschlussreaktanzwerten vorgenommen werden. Zur Vergrößerung der Datendichte können Kurzschlussreaktanzwerte auch an weiteren Messorten innerhalb eines Leitungsabschnitts des Stromnetzes gemessen werden. Die gemessenen Kurzschlussreaktanzwerte und die jeweiligen Messorte können dann in ein zur Durchführung des erfindungsgemäßen Verfahrens eingerichtetes Distanzschutzrelais eingegeben werden. Bei einer Initialisierung eines zur Durchführung des erfindungsgemäßen Verfahrens eingerichteten Distanzschutzrelais kann das Distanzschutzrelais aus den eingegebenen Kurzschlussreaktanzwerten und Messorten Parameter der mathematischen Funktionen selbsttätig ermitteln, welche die Distanz-Reaktanz-Kurve der einzelnen Leitungsabschnitte darstellen. Es muss im Zusammenhang mit Autotransformatorsystemen keine komplette Simulation bzw. Messkampagne gemacht werden. Auch werden nicht, wie herkömmlich, Leitungsparameter, wie beispielsweise Impedanz bzw. Reaktanz pro Kilometer, berücksichtigt, wie es im Zusammenhang mit konventionellen Leitungen bekannt ist.

Vorteilhafterweise werden an den Messorten des Leitungsabschnitts für jede vorliegende Stromphase Kurzschlussreaktanzwerte erfasst. Beispielsweise können an einem Messort einen Kurzschlussreaktanzwert für einen Positive-Feeder und ein Kurzschlussreaktanzwert für einen Negative-Feeder gemessen werden. Somit muss für jeden an einem Messort gemessenen Kurzschlussreaktanzwert der jeweilige Messort innerhalb eines Leitungsabschnitts nur einmal in ein zur Durchführung des erfindungsgemäßen Verfahrens eingerichtetes Distanzschutzrelais eingegeben werden. Durch diese weitere Datenreduzierung können drei- oder mehrdimensionale Punkte entstehen, welche einen Wert für den jeweiligen Messort innerhalb eines Leitungsabschnitts und für jede Stromphase einen Kurzschlussreaktanzwert enthält. Somit können von einem zur Durchführung des Verfahrens eingerichteten Distanzschutzrelais mehrere Distanz-Reaktanz-Kurven gleichzeitig modelliert werden, anstatt, wie bislang üblich, solche Distanz-Reaktanz-Kurve einzeln zu betrachten und zu verarbeiten.

Es wird des Weiteren als vorteilhaft erachtet, wenn die mathematische Funktion durch eine Ausgleichsrechnung aus den abschnittspezifischen Parametern des Leitungsabschnitts hergeleitet wird. Beispielsweise kann ein Curve-Fitting-Verfahren durchgeführt werden, um die mathematische Funktion aus den abschnittspezifischen Parametern herzuleiten.

Eine weitere vorteilhafte Ausgestaltung sieht vor, dass als abschnittspezifische Parameter des Leitungsabschnitts leitungsspezifische Parameter und elektrische Parameter eines mit dem Netzabschnitt verbundenen Autotransformators erfasst werden. Die mathematische Funktion kann aus diesen Parametern durch eine Berechnung hergeleitet werden. Anstatt der gemessenen Kurzschlussreaktanzwerte können für jeden Leitungsabschnitt dessen Länge, Leitungsparameter eines Positive-Feeders und eines Negative-Feeders sowie elektrische Parameter des Autotransformators berücksichtigt werden. Dadurch ist es einem zur Durchführung des Verfahrens eingerichteten Distanzschutzrelais möglich, eine Distanz-Reaktanz-Kurve zu berechnen.

Gemäß einer weiteren vorteilhaften Ausgestaltung wird für jeden Leitungsabschnitt des Stromnetzes eine entsprechende eigene mathematischen Funktion aus den abschnittspezifischen Parametern des jeweiligen Leitungsabschnitts hergeleitet, wobei die mathematischen Funktionen miteinander zu einer stromnetzspezifischen mathematischen Funktion kombiniert werden. Hierdurch lässt sich eine Distanz-Reaktanz-Kurve für das gesamte Stromnetz modellieren. Dabei können die einzelnen abschnittspezifischen mathematischen Funktionen als abschnittspezifische Kurven graphisch dargestellt und graphisch miteinander zu einer stromnetzspezifischen Kurve kombiniert werden.

Nach einer weiteren vorteilhaften Ausgestaltung werden der Kurzschluss, der zu dem Kurzschluss ermittelte Kurzschlussreaktanzwert und der abgeleitete Ort des Kurzschlusses innerhalb des Leitungsabschnitts gemeinsam signalisiert. Beispielsweise kann eine akustische und/oder eine optische Signalisierung erfolgen.

Zum Orten eines Kurzschlusses in einem wenigstens einen Leitungsabschnitt umfassenden Stromnetz, insbesondere eines Autotransformatorsystems, umfasst das mit dem Stromnetz verbundene, erfindungsgemäße Distanzschutzrelais zumindest einen Mikrocontroller, Messwerteingänge für eine Erfassung von Spannungs- und Stromwerten, wenigstens einen Schaltkontakt nach außen und wenigstens eine Steuer- und Konfigurationsschnittstelle. Mit diesem Distanzschutzrelais sind die oben mit Bezug auf das Verfahren genannten Vorteile entsprechend verbunden.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung der Ausführungsbeispiele, die im Zusammenhang mit den schematischen Zeichnungen näher erläutert werden. Es zeigen:
- Figur 1: eine graphische Darstellung einer Distanz-Reaktanz-Kurve für einen Positive-Feeder und einer Distanz-Reaktanz-Kurve für einen Negative-Feeder,
- Figur 2: eine graphische Darstellung der in Figur 1 gezeigten Distanz-Reaktanz-Kurve für den Positive-Feeder,
- Figur 3: eine graphische Darstellung eines Abschnitts der in Figur 2 gezeigten Distanz-Reaktanz-Kurve für den Positive-Feeder,
- Figur 4: eine graphische Darstellung des in Figur 3 gezeigten Abschnitts der Distanz-Reaktanz-Kurve für den Positive-Feeder in Zusammenschau mit Kurzschlussreaktanzwerten,
- Figur 5: eine graphische Darstellung eines aus den in Figur 4 gezeigten Kurzschlussreaktanzwerten gebildeten Graphs in Zusammenschau mit einer graphisch dargestellten mathematischen Funktion,
- Figur 6: eine graphische Darstellung des in Figur 3 gezeigten Abschnitts der Distanz-Reaktanz-Kurve für den Positive-Feeder in Zusammenschau mit einer graphischen Darstellung einer hergeleiteten mathematischen Funktion, und
- Figur 7: eine graphische Darstellung der in Figur 2 gezeigten Distanz-Reaktanz-Kurve für den Positive-Feeder in Zusammenschau mit graphischen Darstellungen von miteinander verbundenen und für jeden Abschnitt der Distanzreaktanzkurve einzeln hergeleiteten mathematischen Funktionen.

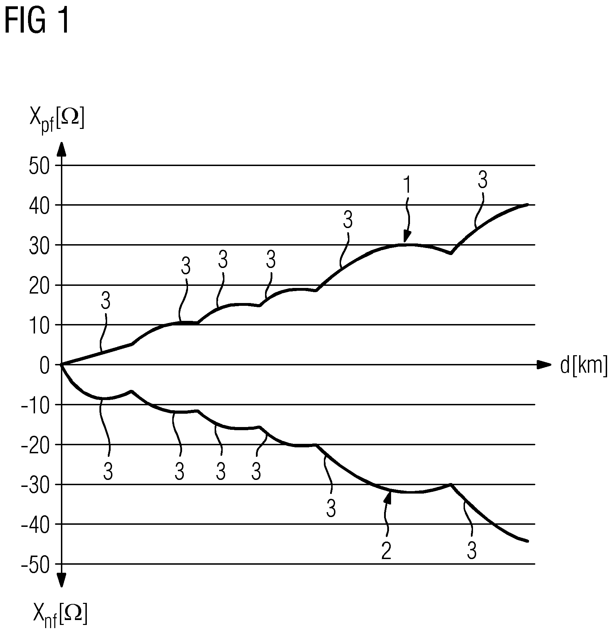

Figur 1 zeigt eine graphische Darstellung einer Distanz-Reaktanz-Kurve 1 für einen Positive-Feeder und einer Distanz-Reaktanz-Kurve 2 für einen Negative-Feeder eines Stromnetzes eines Autotransformatorsystems. Es ist die Kurzschlussreaktanz X des Stromnetzes gegen den Ort innerhalb des Stromnetzes aufgetragen. Jede Distanz-Reaktanz-Kurve 1 bzw. 2 weist mehrere Abschnitte 3 auf, die jeweils einem Leitungsabschnitt eines Stromnetzes zugeordnet sind und welche jeweils eine Distanz-Reaktanz-Kurve für den jeweiligen Leitungsabschnitt darstellen. Die Distanz-Reaktanz-Kurven 1 und 2 werden im Folgenden separat betrachtet, um eine beispielhafte Ausgestaltung des erfindungsgemäßen Verfahrens zu erläutern.

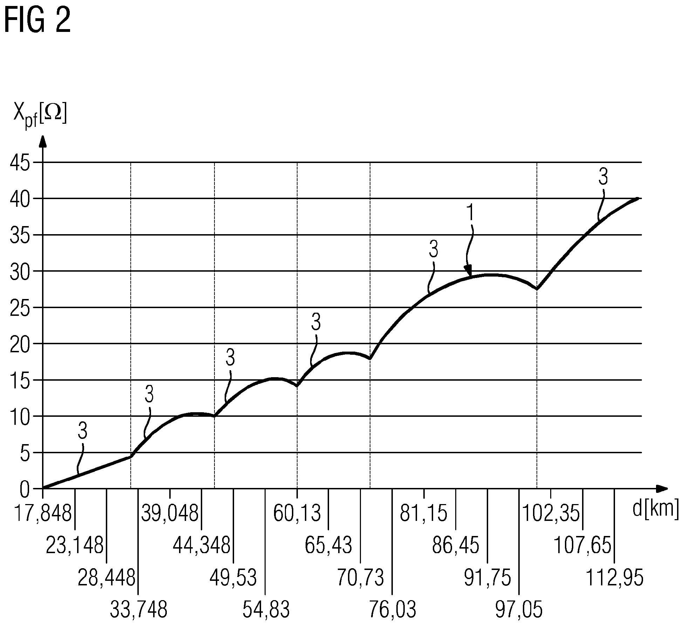

Figur 2 zeigt eine graphische Darstellung der in Figur 1 gezeigten Distanz-Reaktanz-Kurve 1 für den Positive-Feeder des Stromnetzes des Autotransformatorsystems. Die Distanz-Reaktanz-Kurve 1 ist entsprechend den einzelnen Leitungsabschnitten bzw. Abschnitten 3 unterteilt. Jeder Abschnitt 3 stellt einen Verlauf der Distanz-Reaktanz-Kurve eines zwischen zwei Transformatoren angeordneten Leitungsabschnitts dar. Die Distanz-Reaktanz-Kurve 1 ist somit auf "physikalische" Art und Weise in Abschnitte 3 unterteilt.

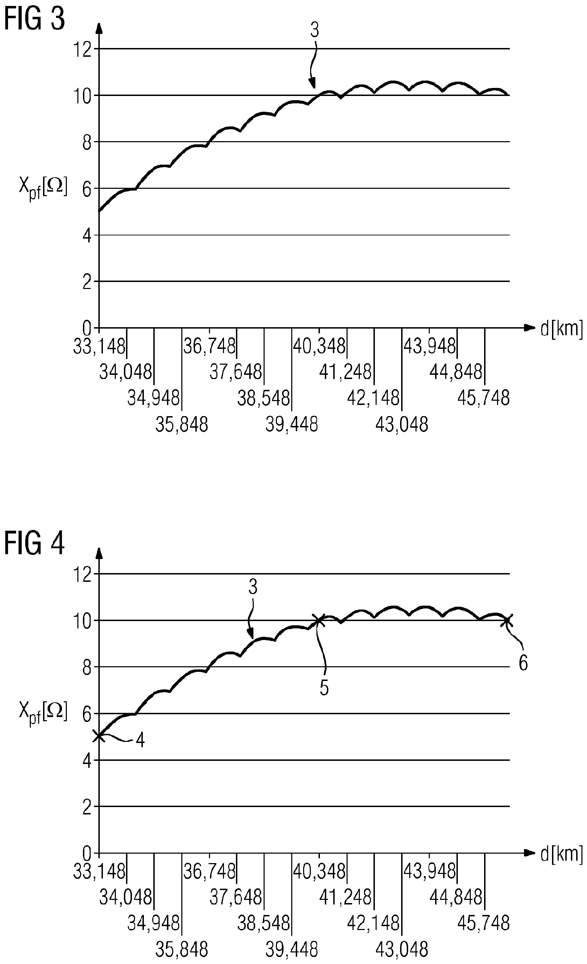

Figur 3 zeigt eine graphische Darstellung eines Abschnitts 3 der in Figur 2 gezeigten Distanz-Reaktanz-Kurve 1 für den Positive-Feeder des Stromnetzes des Autotransformatorsystems.

Figur 4 zeigt eine graphische Darstellung des in Figur 3 gezeigten Abschnitts 3 der Distanz-Reaktanz-Kurve 1 für den Positive-Feeder des Stromnetzes des Autotransformatorsystems in Zusammenschau mit gemessenen Kurzschlussreaktanzwerten 4, 5 und 6. Der Kurzschlussreaktanzwert 4 wurde am Anfang, der Kurzschlussreaktanzwert 5 in der Mitte und der Kurzschlussreaktanzwert 6 am Ende des dem Abschnitt 3 zugeordneten Leitungsabschnitt des Stromnetzes gemessen. Die Kurzschlussreaktanzwerte 4, 5 und 6 werden in ein zur Durchführung des Verfahrens eingerichtetes Distanzschutzrelais eingegeben.

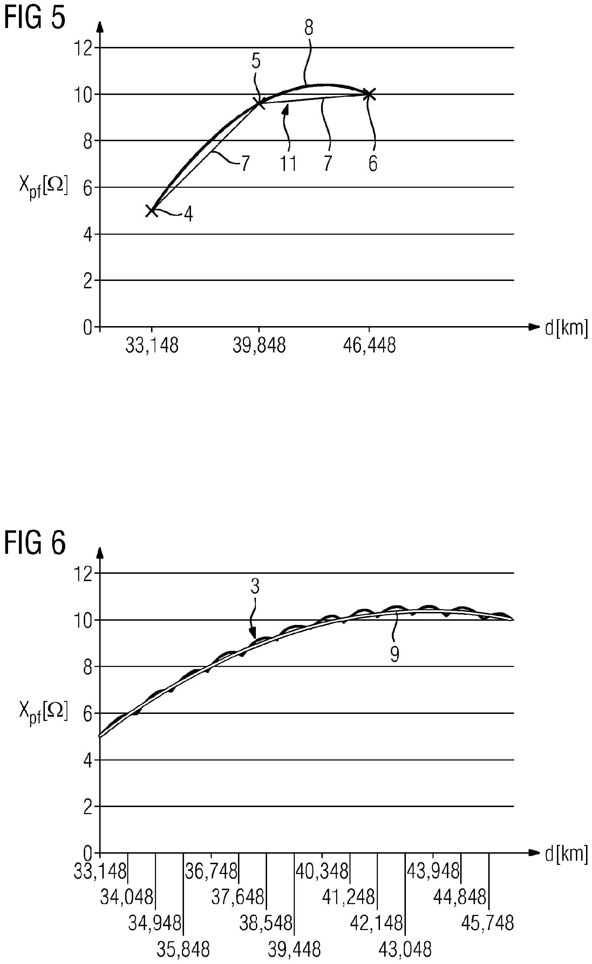

Figur 5 zeigt eine graphische Darstellung eines aus den in Figur 4 gezeigten Kurzschlussreaktanzwerten 4, 5 und 6 gebildeten Graphs 11 in Zusammenschau mit einem Graph 8 einer graphisch dargestellten mathematischen Funktion. Der Graph 11 entsteht durch die die Kurzschlussreaktanzwerte 4 und 5 bzw. 5 und 6 miteinander verbindende Geraden 7. Der Graph 8 wurde mittels eines zur Durchführung des Verfahrens eingerichteten Distanzschutzrelais unter Verwendung eines Curve-Fitting-Verfahrens, beispielsweise MMSE ("Minimum Mean Square Error"), ermittelt, wodurch die Parameter des Graphs 8 ermittelt werden.

Figur 6 zeigt eine graphische Darstellung des in Figur 3 gezeigten Abschnitts 3 der Distanz-Reaktanz-Kurve des dem Abschnitt zugeordneten Leitungsabschnitts des Stromnetzes für den Positive-Feeder in Zusammenschau mit einer graphischen Darstellung einer durch Interpolation hergeleiteten mathematischen Funktion. Der Graph 9 der hergeleiteten mathematischen Funktion wurde aus den Parametern des in Figur 5 gezeigten Graphs 8 modelliert. Die zu dem Graph 9 gehörende mathematische Funktion stellt die Kurzschlussreaktanz des dem Abschnitt 3 zugeordneten Leitungsabschnitts als Funktion eines Ortes innerhalb des Leitungsabschnitts dar.

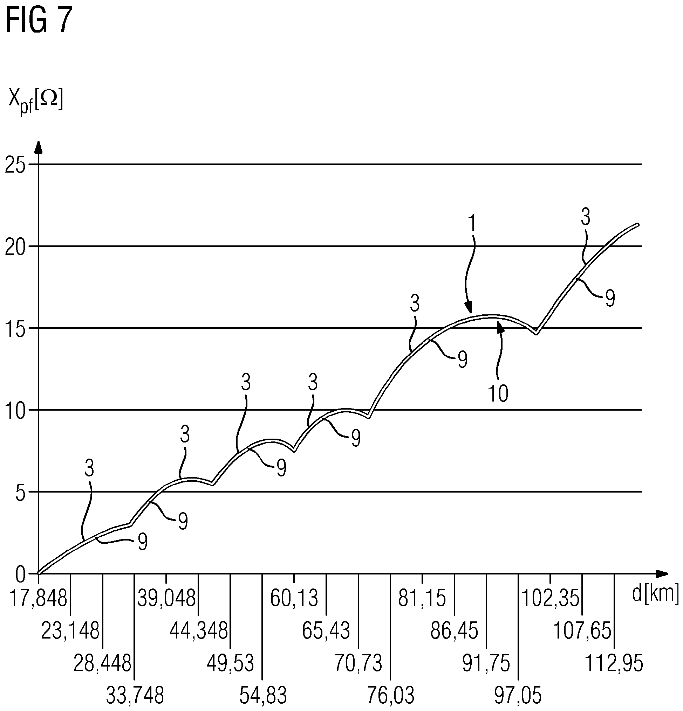

Figur 7 zeigt eine graphische Darstellung der in Figur 2 gezeigten Distanz-Reaktanz-Kurve 1 für den Positive-Feeder in Zusammenschau mit graphischen Darstellungen von miteinander verbundenen und für jeden Abschnitt 3 der Distanz-Reaktanz-Kurve einzeln hergeleiteten mathematischen Funktionen. Hierzu wurde die Vorgehensweise, wie sie im Zusammenhang mit den Figuren 2 bis 6 beschrieben wurde, auch auf die Übrigen Abschnitte 3 der Distanz-Reaktanz-Kurve 1 angewendet. Entsprechend Figur 7 sind somit die Graphen der die jeweiligen Abschnitte 3 modellierenden mathematischen Funktionen graphisch miteinander zu einer darstellbaren, stromnetzspezifischen mathematischen Distanz-Reaktanz-Kurve 10 kombiniert worden.

Entsprechend kann auch die Distanz-Reaktanz-Kurve 2 des Negative-Feeders des Stromnetzes modelliert werden.

Obwohl die Erfindung im Detail durch die bevorzugten Ausführungsbeispiele näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

## Patentansprüche

1. Verfahren zum Orten eines Kurzschlusses in einem wenigstens einen Leitungsabschnitt mit nicht linearer Distanz-Reaktanz-Kurve umfassenden Stromnetz, insbesondere eines Autotransformatorsystems oder eines Systems mit Booster Transformatoren, aufweisend die Schritte:
- Erfassen von abschnittspezifischen Parametern der Leitungsabschnitte des Stromnetzes, **gekennzeichnet durch**,
- Herleiten von wenigstens einer entsprechenden eigenen mathematischen Funktion für jeden Leitungsabschnitt des Stromnetzes aus den abschnittspezifischen Parametern des jeweiligen Leitungsabschnitts, wobei für Leitungsabschnitte mit nicht linearer Distanz-Reaktanz-Kurve die mathematische Funktion eine Kurzschlussreaktanz des Leitungsabschnitts als nicht lineare Funktion eines Ortes innerhalb des Leitungsabschnitts mit nicht linearer Distanz-Reaktanz-Kurve darstellt und wobei für Leitungsabschnitte mit linearer Distanz-Reaktanz-Kurve die mathematische Funktion eine Kurzschlussreaktanz des Leitungsabschnitts als lineare Funktion eines Ortes innerhalb des Leitungsabschnitts mit linearer Distanz-Reaktanz-Kurve darstellt;
- Kombinieren der für jeden Leitungsabschnitt des Stromnetzes hergeleiteten, entsprechenden, eigenen mathematischen Funktionen miteinander zu einer stromnetzspezifischen mathematischen Funktion und
- Ableiten des Ortes des Kurzschlusses innerhalb eines Leitungsabschnitts des Stromnetzes aus den für jeden Leitungsabschnitt des Stromnetzes hergeleiteten, entsprechenden eigenen mathematischen Funktionen und/oder der stromnetzspezifischen mathematischen Funktion und einem zu dem Kurzschluss ermittelten Kurzschlussreaktanzwert.

2. Verfahren nach Anspruch 1, **dadurch gekennzeichnet, dass** die mathematische Funktion in Form eines Polynoms vom Grad n≥2 hergeleitet wird.

3. Verfahren nach Anspruch 1 oder 2, **dadurch gekennzeichnet, dass** als abschnittspezifische Parameter des Leitungsabschnitts an wenigstens drei Messorten des Leitungsabschnitts gemessene Kurzschlussreaktanzwerte des Leitungsabschnitts erfasst werden.

4. Verfahren nach Anspruch 3, **dadurch gekennzeichnet, dass** an den Messorten des Leitungsabschnitts für jede vorliegende Stromphase Kurzschlussreaktanzwerte erfasst werden.

5. Verfahren nach Anspruch 3 oder 4, **dadurch gekennzeichnet, dass** die mathematische Funktion durch eine Ausgleichsrechnung aus den abschnittspezifischen Parametern des Leitungsabschnitts hergeleitet wird.

6. Verfahren nach Anspruch 1 oder 2, **dadurch gekennzeichnet, dass** als abschnittspezifische Parameter des Leitungsabschnitts leitungsspezifische Parameter und elektrische Parameter eines mit dem Netzabschnitt verbundenen Autotransformators erfasst werden.

7. Verfahren nach einem der Ansprüche 1 bis 6, **dadurch gekennzeichnet, dass** der Kurzschluss, der zu dem Kurzschluss ermittelte Kurzschlussreaktanzwert und der abgeleitete Ort des Kurzschlusses innerhalb des Leitungsabschnitts signalisiert werden.

8. Distanzschutzrelais mit zumindest einem Mikrocontroller, Messwerteingängen für eine Erfassung von Spannungs- und Stromwerten, wenigstens einem Schaltkontakt nach außen und wenigstens einer Steuer- und Konfigurationsschnittstelle, zum Orten eines Kurzschlusses in einem wenigstens einen Leitungsabschnitt mit nicht linearer Distanz-Reaktanz-Kurve umfassenden Stromnetz eines Autotransformatorsystems oder eines Systems mit Booster Transformatoren, wobei das Distanzschutzrelais mit dem Stromnetz verbindbar ist,
**dadurch gekennzeichnet, dass** das Distanzschutzrelais ausgebildet ist, die folgenden Schritte auszuführen:
- Erfassen von abschnittspezifischen Parametern der Leitungsabschnitte des Stromnetzes;
- Herleiten von wenigstens einer entsprechenden eigenen mathematischen Funktion für jeden Leitungsabschnitt des Stromnetzes aus den abschnittspezifischen Parametern des jeweiligen Leitungsabschnitts, wobei für Leitungsabschnitte mit nicht linearer Distanz-Reaktanz-Kurve die mathematische Funktion eine Kurzschlussreaktanz des Leitungsabschnitts als nicht lineare Funktion eines Ortes innerhalb des Leitungsabschnitts mit nicht linearer Distanz-Reaktanz-Kurve darstellt und wobei für Leitungsabschnitte mit linearer Distanz-Reaktanz-Kurve die mathematische Funktion eine Kurzschlussreaktanz des Leitungsabschnitts als lineare Funktion eines Ortes innerhalb des Leitungsabschnitts mit linearer Distanz-Reaktanz-Kurve darstellt;
- Kombinieren der für jeden Leitungsabschnitt des Stromnetzes hergeleiteten, entsprechenden, eigenen mathematischen Funktionen miteinander zu einer stromnetzspezifischen mathematischen Funktion und
- Ableiten des Ortes des Kurzschlusses innerhalb eines Leitungsabschnitts des Stromnetzes aus den für jeden Leitungsabschnitt des Stromnetzes hergeleiteten, entsprechenden eigenen mathematischen Funktionen und/oder der stromnetzspezifischen mathematischen Funktion und einem zu dem Kurzschluss ermittelten Kurzschlussreaktanzwert.

## Claims

1. Method for locating a short circuit in an electrical grid comprising at least one line section with a non-linear distance reactance curve, in particular of an autotransformer system or a system with booster transformers, having the steps:
- Detecting section-specific parameters of the line sections of the electrical grid, **characterised by**
- Deriving at least one corresponding separate mathematical function for each line section of the electrical grid from the section-specific parameters of the respective line section, wherein for line sections with a non-linear distance reactance curve, the mathematical function represents a short-circuit reactance of the line section as a non-linear function of a location within the line section with a non-linear distance reactance curve and wherein for line sections with a linear distance reactive curve, the mathematical function represents a short-circuit reactance of the line section as a linear function of a location within the line section with a linear distance reactance curve;
- Combining the corresponding, separate mathematical functions derived for each line section of the electrical grid with one another in order to form an electrical grid-specific mathematical function and
- Deducing the location of the short circuit within a line section of the electrical grid from the corresponding, separate mathematical functions derived for each line section of the electrical grid and/or the electrical-grid specific mathematical function and a short-circuit reactance value determined with respect to the short circuit.

2. Method according to claim 1, **characterised in that** the mathematical function is derived in the form of a polynomial of the degree n≥2.

3. Method according to claim 1 or 2, **characterised in that** measured short-circuit reactance values of the line section are detected as section-specific parameters of the line section at at least three measuring locations of the line section.

4. Method according to claim 3, **characterised in that** short-circuit reactance values are detected for each existing current phase at the measuring locations of the line section.

5. Method according to claim 3 or 4, **characterised in that** the mathematical function is derived from the section-specific parameters of the line section by means of a compensation calculation.

6. Method according to claim 1 or 2, **characterised in that** line-specific parameters and electrical parameters of an autotransformer connected to the electrical grid are detected as section-specific parameters of the line section.

7. Method according to one of claims 1 to 6, **characterised in that** the short circuit, the short-circuit reactance value determined with respect to the short circuit and the deduced location of the short circuit within the line section are signalled.

8. Distance protection relay having at least one microcontroller, measured value inputs for detecting voltage and current values, at least one externally-facing switching contact and at least one control and configuration interface for locating a short circuit in an electrical grid of an autotransformer system or a system with booster transformers comprising at least one line section with a non-linear distance reactance curve , wherein the distance protection relay can be connected to the electrical grid,
**characterised in that** the distance protection relay is embodied to execute the follow steps:
- Detecting section-specific parameters of the line sections of the electrical grid;
- Deriving at least one corresponding separate mathematical function for each line section of the electrical grid from the section-specific parameters of the respective line section, wherein for line sections with a non-linear reactance curve, the mathematical function represents a short-circuit reactance of the line section as a non-linear function of a location within the line section with a non-linear distance reactance curve and wherein for line sections with a linear distance reactance curve, the mathematical function represents a short-circuit reactance of the line section as a linear function of a location within the line section with a linear distance reactance curve;
- Combining the corresponding, separate mathematical functions derived for each line section of the electrical grid with one another in order to form an electrical grid-specific mathematical function and
- Deducing the location of the short circuit within a line section of the electrical grid from the corresponding, separate mathematical functions derived for each line section of the electrical grid and/or the electrical grid-specific mathematical function and a short-circuit reactance value determined with respect to the short circuit.

## Revendications

1. Procédé de localisation d'un court-circuit dans un réseau de courant comprenant au moins un tronçon de ligne à courbe de distance
- réactance non linéaire, notamment d'un système à autotransformateur ou d'un système à transformateurs boosters, comportant les stades :
- relevé de paramètres, spécifiques à un tronçon, des tronçons de lignes du réseau de courant, **caractérisé par**
- production d'au moins une fonction mathématique propre correspondante, pour chaque tronçon de ligne du réseau de courant, à partir des paramètres, spécifiques à un tronçon, du tronçon de ligne respectif, dans lequel, pour des tronçons de lignes à courbe de distance - réactance non linéaire, la fonction mathématique représente une réactance de court-circuit du tronçon de ligne sous la forme d'une fonction non linéaire d'une localisation dans le tronçon de ligne à courbe de distance - réactance non linéaire et dans lequel, pour des tronçons de lignes à courbe de distance - réactance linéaire la fonction mathématique représente une réactance de court-circuit du tronçon de ligne sous la forme d'une fonction linéaire d'une localisation dans le tronçon de ligne à courbe de distance - réactance linéaire ;
- combinaison entre elles des fonctions mathématiques propres, correspondantes, produites pour chaque tronçon de ligne du réseau courant et
- déduction de la localisation du court-circuit dans un tronçon de ligne du réseau de courant, à partir des fonctions mathématiques propres correspondantes produites pour chaque tronçon de ligne du réseau de courant et/ou de la fonction mathématique spécifique au réseau de courant et d'une valeur de réactance de court-circuit déterminée sur le court-circuit.

2. Procédé suivant la revendication 1, **caractérisé en ce que** l'on produit la fonction mathématique sous la forme d'un polynôme de degré n ≥ 2.

3. Procédé suivant la revendication 1 ou 2, **caractérisé en ce que** l'on relève comme paramètres spécifiques à un tronçon du tronçon de ligne des valeurs de réactance de court-circuit du tronçon de ligne mesurées en au moins trois emplacements de mesure du tronçon de ligne.

4. Procédé suivant la revendication 3, **caractérisé en ce que** l'on relève des valeurs de réactance de court-circuit aux emplacements de mesure du tronçon de ligne pour chaque phase de courant présente.

5. Procédé suivant la revendication 3 ou 4, **caractérisé en ce que** l'on produit la fonction mathématique par un calcul de compensation à partir des paramètres, spécifiques à un tronçon, du tronçon de ligne.

6. Procédé suivant la revendication 1 ou 2, **caractérisé en ce que** l'on relève comme paramètres spécifiques à un tronçon, du tronçon de ligne des paramètres spécifiques à une ligne et des paramètres électriques d'un autotransformateur relié au tronçon du réseau.

7. Procédé suivant l'une des revendications 1 à 6, **caractérisé en ce que** l'on signale le court-circuit, la valeur de réactance de court-circuit déterminée par rapport au court-circuit et la localisation qui s'en déduit du court-circuit dans le tronçon de ligne.

8. Relais de télé-protection comprenant au moins une micro-unité de commande, des entrées de valeurs de mesure pour un relevé de valeurs de tension et de courant, au moins un contact de coupure vers l'extérieur et au moins une interface de commande et de configuration, pour la localisation d'un court-circuit dans un réseau de courant comprenant au moins un tronçon de ligne à courbe de distance - réactance non linéaire, d'un système à autotransformateur ou d'un système ayant des transformateurs boosters, dans lequel le relais de télé-protection peut être relié au réseau de courant,
**caractérisé en ce que** le relais de télé-protection est constitué pour effectuer les stades suivants :
- relevé de paramètres, spécifiques à un tronçon, des tronçons de lignes du réseau de courant, **caractérisé par**
- production d'au moins une fonction mathématique propre correspondante, pour chaque tronçon de ligne du réseau de courant, à partir des paramètres, spécifiques à un tronçon, du tronçon de ligne respectif, dans lequel, pour des tronçons de lignes à courbe de distance - réactance non linéaire, la fonction mathématique représente une réactance de court-circuit du tronçon de ligne sous la forme d'une fonction non linéaire d'une localisation dans le tronçon de ligne à courbe de distance - réactance non linéaire et dans lequel, pour des tronçons de lignes à courbe de distance - réactance linéaire la fonction mathématique représente une réactance de court-circuit du tronçon de ligne sous la forme d'une fonction linéaire d'une localisation dans le tronçon de ligne à courbe de distance - réactance linéaire ;
- combinaison entre elles des fonctions mathématiques propres correspondantes, produites pour chaque tronçon de ligne du réseau de courant et
- déduction de la localisation du court-circuit dans un tronçon de ligne du réseau de courant, à partir des fonctions mathématiques propres correspondantes produites pour chaque tronçon de ligne du réseau de courant et/ou de la fonction mathématique spécifique au réseau de courant et d'une valeur de réactance de court-circuit déterminée par rapport au court-circuit.
